# EUROPEAN PATENT APPLICATION

(11) **EP 2 280 594 A1**
(43) Date of publication of application: **02.02.2011**
(21) Application number: 08874395.0
(22) Date of filing: 22.12.2008
(51) Int. Cl.: H05K 3/46

(54) **PRINTED WIRING BOARD AND METHOD FOR MANUFACTURING THE SAME**

(30) Priority: 19.05.2008 US 71790 P
(71) Applicant: Ibiden Co., Ltd., Ogaki-shi, Gifu 503-8604 (JP)
(72) Inventor: TAKAHASHI, Michimasa, Ogaki-shi Gifu 503-8503 (JP)
(74) Representative: HOFFMANN EITLE
(86) International application number: PCT/JP2008/073344
(87) International publication number: WO 2009/141928

(57) **Abstract**

A printed wiring board has a first substrate (10) with multiple wiring layers, and a second substrate (20) with wiring layers whose conductor density is set higher than that of the first substrate (10). The first substrate (10) and the second substrate (20) are electrically connected through each wiring layer, and the second substrate (20) is embedded in an accommodation section (100a).

## Description

### Technical Field

The present invention is related to a printed wiring board a method for manufacturing the same.

### Background Art

A printed wiring board and a method of manufacturing the same are described in, for example, Patent Literature 1. In such a printed wiring board, a high-density region in which conductive bumps are arranged densely, and a low-density region in which conductive bumps are arranged sparsely are both formed in a single substrate. The printed wiring board is structured by properly combining those high-density regions and low-density regions.

Patent Literature 1: Japanese Patent No. 3795270

### Disclosure of the Invention

### Problem to be Solved by the Invention

The apparatus described in Patent Literature 1 forms a low-density conductor region and a high-density conductor region in one substrate. When a defect exists only in a high-density conductor region, the whole substrate, including a non-defective low-density conductor region, is treated as a defective product. Also, when a defect exists only in a low-density conductor region, the whole substrate, including a non-defective high-density conductor region, is treated as a defective product. Therefore, a loss of material is substantial.

The present invention has been made to address the above Problem. The present invention is directed to a printed wiring board and a method for manufacturing the same, whereby loss of material from manufacturing of printed wiring boards is reduced. As well, the present invention is directed to providing a printed wiring board with ideal electric properties and a method of manufacturing the same.

### Means for Solving the Problem

To achieve the above objects, the printed wiring board according to a first aspect of the present invention comprises: a first substrate having a conductor; and at least one second substrate whose conductor density is higher than that of the first substrate, the at least one second substrate having a conductor, wherein: the conductor of the first substrate and the conductor of the second substrate are electrically connected; and at least one of the first substrate and the second substrate is embedded in the printed wiring board.

The number of wiring layers formed of the conductor of the second substrate may be greater than the number of wiring layers of the first substrate in a region thereof where the thickness of the first substrate is equal to that of the second substrate.

Each of the first substrate and the second substrate may have an insulating layer; and the conductor density on the insulating layer of the second substrate may be higher than the conductor density on the insulating layer of the first substrate.

The first substrate and the second substrate may have a lower wiring layer and an upper wiring layer electrically connected through vias in an interlayer insulating layer; and the number of vias per unit interlayer insulating layer of the second substrate may be greater than the number of vias per unit interlayer insulating layer of the first substrate.

The first substrate and the second substrate may be separated from each other; and a resin may exist in at least a portion of a space between the first substrate and the second substrate.

An insulating material may be disposed at least one of the front and back of the resin; and the resin comprised in the insulating material and the resin in the space between the first substrate and the second substrate may be made of the same material.

At least one of the first substrate and the second substrate may have an insulating layer containing an inorganic material.

At least one of the insulating layer of the first substrate and the insulating layer of the second substrate may have at least one cloth layer with the inorganic material.

The number of insulating layers containing the inorganic material of the first substrate may be greater than the number of insulating layers containing the inorganic material of the second substrate.

The thickness of at least a portion of the conductor of the second substrate may be smaller than the thickness of the conductor of the first substrate.

At least one electronic component may be electrically connected to at least one of the first substrate and the second substrate.

At least one electronic component may be electrically connected to the second substrate.

The method for manufacturing a printed wiring board according to a second aspect of the present invention may comprise: a first step of producing a first substrate having a conductor; a second step of producing, on a single substrate, a considerable number of second substrates having a conductor; a third step of forming an accommodation section, which is a space for accommodating the second substrate, in the first substrate produced in the first step; a fourth step of accommodating at least one of the second substrates in the accommodation section formed in the third step; a fifth step of electrically connecting the conductor of the first substrate and the conductor of the second substrate; and a sixth step of embedding the second substrate by laminating a predetermined material on the second substrate accommodated in the fourth step and on the first substrate which accommodates the second substrate.

A substrate inspecting step of inspecting, prior to the fourth step, each of the first substrate fabricated in the first step and the second substrates fabricated in the second step on a pass-fail basis may be further comprised; and in the fourth step, at least one of the second substrates determined to be normal in the substrate inspecting step may be accommodated in the accommodation section in the first substrate determined to be normal in the substrate inspecting step.

In the third step, an accommodation section having a space may be formed so that positioning is possible in the space even when the second substrates are accommodated therein.

According to the present invention, a printed wiring board and a method for manufacturing the same, whereby loss of material from manufacturing of printed wiring boards is reduced, can be provided. Also according to the present invention, a printed wiring board with ideal electric properties and a method of manufacturing the same can be provided.

### Brief Description of the Drawings

FIG. 1 is a cross-sectional view schematically illustrating a structure of a printed wiring board in an embodiment of a printed wiring board and a method of manufacturing the same according to the present invention.
FIGS. 2 (a)-(b) are photographs schematically showing a structure of the printed wiring board.
FIG. 3 is a perspective view illustrating a production step of first substrates according to the manufacturing method of the embodiment.
FIG. 4 is a perspective view illustrating a production step of second substrates according to the manufacturing method of the embodiment.
FIGS. 5 (a)-(d) are cross-sectional views illustrating production steps of a first substrate according to the manufacturing method of the embodiment.
FIGS. 6 (a)-(d) are cross-sectional views illustrating production steps of a first wiring layer of a second substrate according to the manufacturing method of the embodiment.
FIGS. 7 (a)-(e) are cross-sectional views illustrating production steps of a second wiring layer of a second substrate according to the manufacturing method of the embodiment.
FIGS. 8 (a)-(e) are cross-sectional views illustrating production steps of a third wiring layer of a second substrate according to the manufacturing method of the embodiment.
FIG. 9 is a cross-sectional view illustrating a step to form an accommodation section in a first substrate.
FIG. 10 is a perspective view illustrating a step to accommodate a second substrate in an accommodation section of a first substrate.
FIG. 11 is a plan view illustrating a phase in which a second substrate is accommodated in an accommodation section.
FIG. 12 is a cross-sectional view illustrating a phase in which a second substrate is accommodated in an accommodation section.
FIGS. 13 (a)-(d) are cross-sectional views illustrating steps for manufacturing a printed wiring board after a second substrate has been accommodated in an accommodation section.
FIG. 14 is a perspective view illustrating a substrate where multiple printed wiring boards according to an embodiment of the present invention are formed.
FIG. 15 is a cross-sectional view illustrating an example modification of a printed wiring board.
FIG. 16 is a cross-sectional view illustrating an example modification of a first substrate.
FIG. 17 is a plan view illustrating example modifications of a first substrate and a second substrate.
FIG. 18 is a cross-sectional view illustrating an example modification of a first substrate and a second substrate.
FIG. 19 is a cross-sectional view illustrating an example modification of a printed wiring board.
FIG. 20 is a cross-sectional view illustrating another example modification of a printed wiring board.
FIG. 21 is a cross-sectional view illustrating still another example modification of a printed wiring board.
FIG. 22 is a cross-sectional view illustrating yet still another example modification of a printed wiring board.
FIG. 23 is a cross-sectional view illustrating yet still further another example modification of a printed wiring board.
FIGS. 24 (a)-(c) are cross-sectional views illustrating a example modification of a method for manufacturing a printed wiring board.

### Explanation of Reference Numerals

10 first substrate
10a non-flexible base material
10b, 20b through connection
10c, 20c cloth layer
11, 12, 21 to 26, 41, 42 wiring layer
20 second substrate
20a non-flexible base material
21a, 21b, 22a, 23a, 23b, 24a, 24b, 25b, 26a interlayer connection portion
30 resin
31-36 insulating material
100, 200 substrate
100a, 301a, 312a accommodation section (hollow section)
101, 201, 202 substrate
300 printed wiring board
310 substrate
311 sacrificial material
312 multilayer film
401, 402, 403 electronic component
501a, 501b, 601a, 601b, 701a, 701b copper foil
502 through hole
503a, 503b conductive film
602 through hole
603a, 603b, 604a, 604b, 606a, 606b, 607a, 607b, 609a, 609b, 703a, 703b c onductive film
605, 608, 702 via

### Best Mode for Carrying out the Invention

The following discussion describes an embodiment in which a printed wiring board and a method of manufacturing the same according to the present invention are embodied.

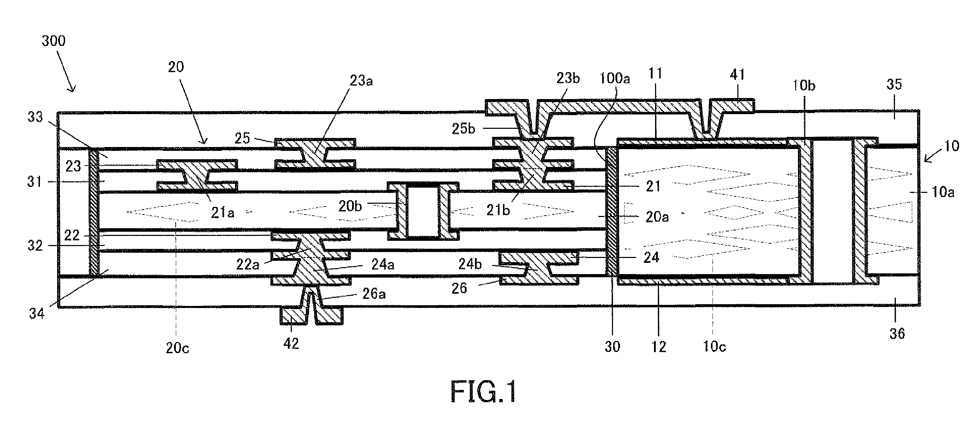

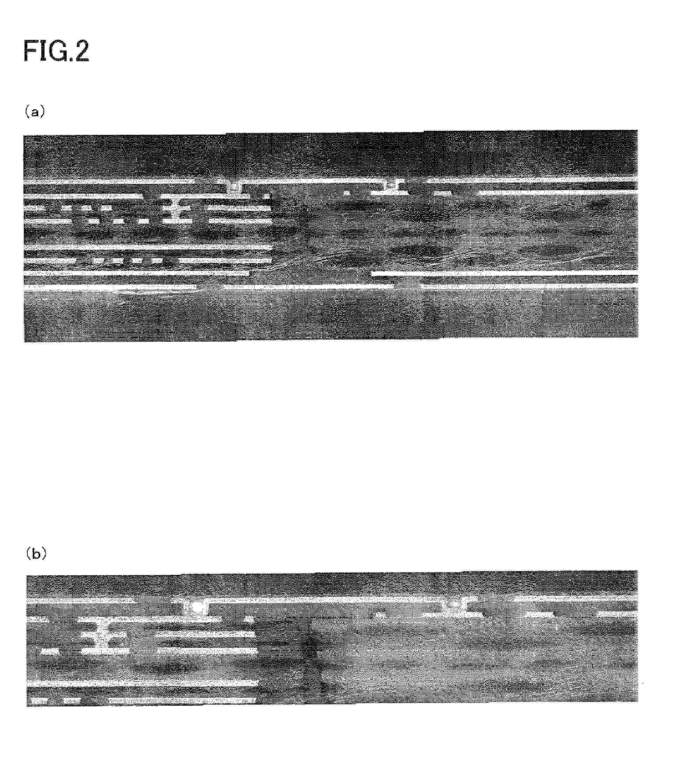

Roughly described, printed wiring board 300 according to an embodiment of the present invention, for example, as its cross-sectional structure is shown in FIG. 1 and its cross-sectional photographs are shown in FIGS. 2(a) and 2(b), has first substrate 10, second substrate 20 embedded in printed wiring board 300, insulating materials 35, 36 disposed on the front and back of first substrate 10 and second substrate 20, and wiring layers 41, 42. Printed wiring board 300 is a so-called rigid multilayer board. Also, first substrate 10 and second substrate 20 structuring printed wiring board 300 are each a multilayer printed wiring board.

First substrate 10 has, for example, non-flexible base material 10a (which corresponds to a core substrate of printed wiring board 300) containing inorganic material (such as glass cloth, silica filler or glass filler). As shown by broken lines in FIG. 1, non-flexible base material 10a has cloth layer 10c made of inorganic material. Also, on the front and back of first substrate 10, wiring layers 11, 12 made of conductor (such as copper) are patterned respectively. Furthermore, for example, by plating through-holes with copper or the like, through connections 10b are formed to connect the conductive patterns on the front and back of the substrate.

Second substrate 20 has non-flexible base material 20a containing inorganic material (such as glass cloth, silica filler or glass filler). Non-flexible base material 20a corresponds to the core substrate of second substrate 20 and its thickness is made smaller (thinner) than the thickness of first substrate 10. As shown by broken lines in FIG. 1, it has cloth layer 20c made of inorganic material. Moreover, formed on the front and back of non-flexible base material 20a are insulating materials 31-34, wiring layers 21-26 made of conductive patterns (such as copper patterns), and interlayer connection portions 21a, 21b, 22a, 23a, 23b, 24a, 24b which electrically connect each wiring layer. More specifically, on front and back of base material 20a, wiring layers 21, 22 are formed; and wiring layers 21, 22 are electrically connected to upper-layer wiring layers 23, 24 by means of interlayer connection portions 21 a, 21 b, 22a made of, for example, copper, formed in insulating materials 31, 32 which insulate the interlayer between them and their upper layers. Furthermore, wiring layers 23, 24 are electrically connected to upper-layer wiring layers 25, 26 by means of interlayer connection portions 23a, 23b, 24a, 24b made of, for example, copper, formed in insulating materials 33, 34 which insulate the interlayer between them and their upper layers. Accordingly, each wiring layer is electrically connected to the other. Also, in base material 20a, through connections 20b which connect the conductive patterns on front and back of the base material are formed by, for example, through-hole plating with copper or the like.

Resin 30 is filled between first substrate 10 and second substrate 20. Namely, first substrate 10 and second substrate 20 are physically connected and adhered (electrically insulated) to each other by means of resin 30. Resin 30 may be formed of the same material as the resin that constitutes upper-layer insulating materials 35, 36.

As described, by connecting first substrate 10 and second substrate 20 through resin 30, adhesiveness between first substrate 10 and second substrate 20 is enhanced. Also, filled resin 30 works as a shock absorber, and when an impact is exerted from the outside, the impact will not be passed on to second substrate 20. Thus, connection reliability of the wiring in second substrate 20, whose wiring density is higher than that of first substrate 10, may be enhanced. In addition, by embedding second substrate 20 which is separately produced, a complex build-up process may be simplified. Furthermore, since insulation layers of first substrate 10 have higher rigidity than insulation layers of second substrate 20, stress exerted on second substrate 20 may be eased.

First substrate 10 and second substrate 20 are set to have the same thickness, and their uppermost layers, wiring layers 11, 12 and wiring layers 25. 26, are formed on the same layer. Namely, the number of wiring layers in unit thickness of second substrate 20 (six: wiring layers 21-26) is set greater than the number of wiring layers in unit thickness of first substrate 10 (two: wiring layers 11, 12). When the number of wiring layers is compared in a region where the two substrates have the same thickness, second substrate 20 has a higher conductor density than first substrate 10 (namely, in the end, printed wiring board 300 containing both substrates). As such, in the printed wiring board, the number of wiring layers formed by the conductors in second substrate 20 is made greater than the number of wiring layers in a region of first substrate 10 that has the same thickness as second substrate 20. With such a structure, a high-density conductor region may be formed easily, and thus it may be easier to make part of the printed wiring board fine-pitched.

Also, the thickness of at least parts of the wiring layers (conductive circuits) of second substrate 20 is the same as the thickness of a conductive circuit of first substrate 10. However, the thickness of at least parts of the conductive circuits of second substrate 20 may be thinner than the thickness of a conductive circuit of first substrate 10.

Insulating materials 35, 36 are made with, for example, an RCF (Resin Coated Copper foil) (or a prepreg may also be used). On their surfaces, wiring layers 41, 42 are formed respectively and are electrically connected to lower-layer wiring layers 11, 12, 25, 26 by means of interlayer connection portions 25b, 26a. Through wiring layers 41, 42, first substrate 10 and second substrate 20 are electrically connected.

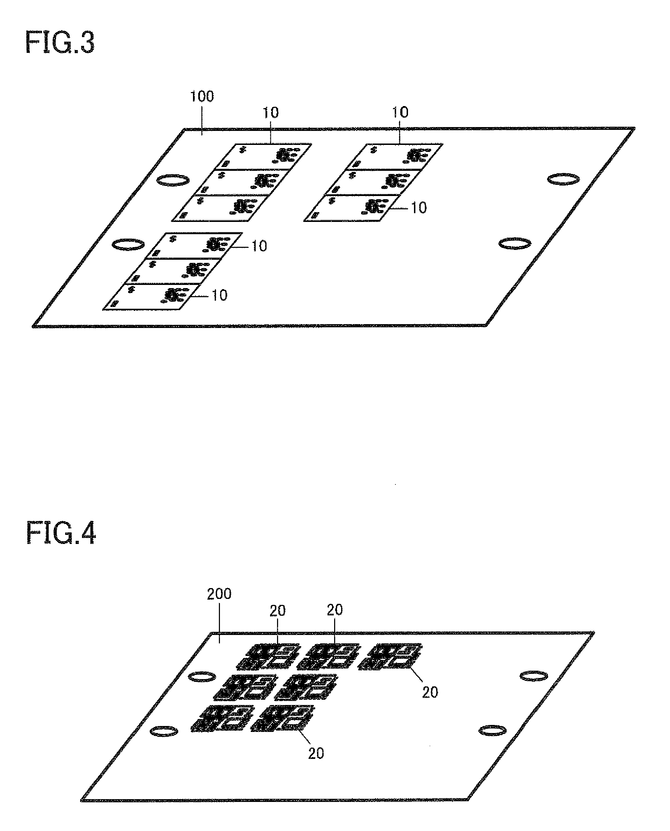

When manufacturing such printed wiring boards, for example, as shown in FIGS. 3 and 4, a sufficient number (for example, approximately 32) of first substrates 10 are formed on a single substrate 100 and a sufficient number (for example, approximately 96) of second substrates 20 on a single substrate 200, using a series of semiconductor processes different from each other.

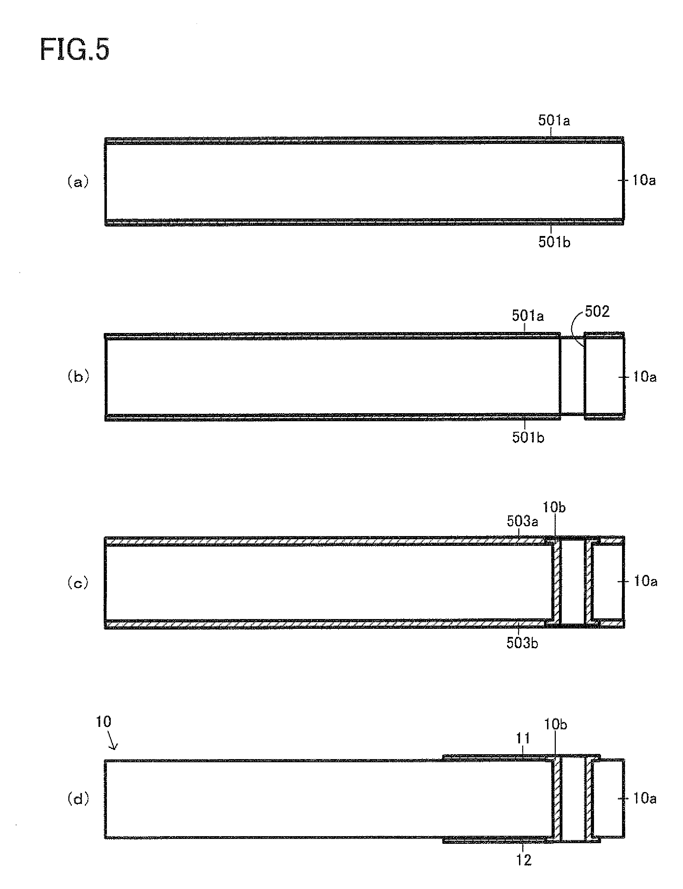

Specifically, when producing first substrate 10, as shown in FIG. 5(a), for example, non-flexible base material 10a having copper foils 501a, 501b respectively on its front and back is prepared. Then, as shown in FIG. 5(b), for example, penetrating holes 502 are formed by a piercing process. After that, the substrate is polished, and as shown in FIG. 5(c), for example, by performing PN plating (such as chemical copper plating and electrical copper plating), through connections 10b are formed which connect the conductive patterns on the front and back of the substrate. Conductive films 503a, 503b made of copper, for example, are also formed respectively on the front and back of non-flexible base material 10a. Then, conductive films 503a, 503b are each patterned by a predetermined photo-etching process (such as washing with acid, laminating a resist, direct drawing (exposing to light), developing, etching, removing the film and so forth) to form wiring layers 11, 12 as shown in FIG. 5(d), for example. Accordingly, first substrate 10 having wiring layers 11, 12 is produced.

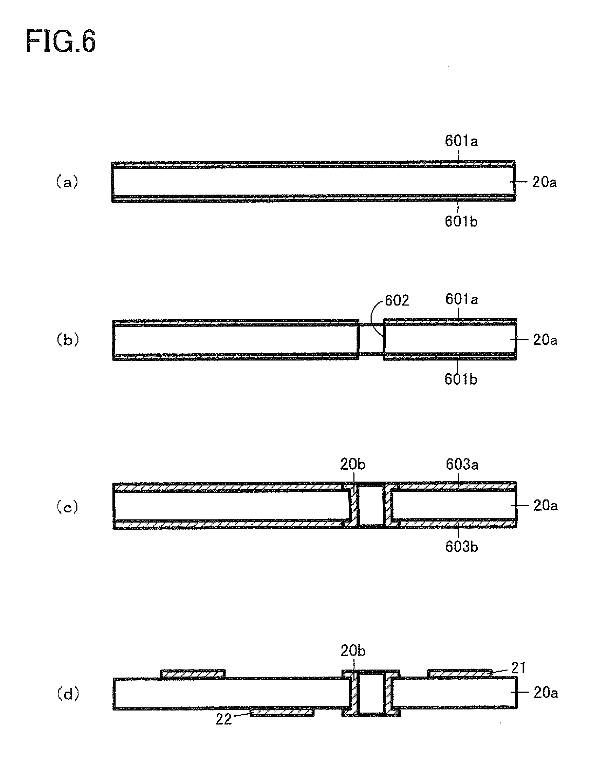

Also, when producing second substrate 20, as shown in FIG. 6(a), for example, non-flexible base material 20a having copper foils 601a, 601b) on its front and back is prepared. Then, as shown in FIG. 6(b), for example, penetrating holes 602 are formed by a piercing process. After that, the substrate is polished, and as shown in FIG. 6(c), for example, by performing PN plating (such as chemical copper plating and electrical copper plating), through connections 20b are formed which connect the conductive patterns on the front and back of the substrate. Conductive films 603a, 603b made of copper, for example, are also formed respectively on the front and back of non-flexible base material 20a. Then, conductive films 603a, 603b are each patterned by a predetermined photo-etching process (such as washing with acid, laminating a resist, direct drawing (exposing to light), developing, etching, removing the film and so forth) to form wiring layers 21, 22 as shown in FIG. 6(d), for example. Accordingly, the first wiring layers of second substrate 20 are produced. Then, an inspection using an image checker or the like is performed and a black oxide treatment is further conducted before starting to form upper-layer second wiring layers.

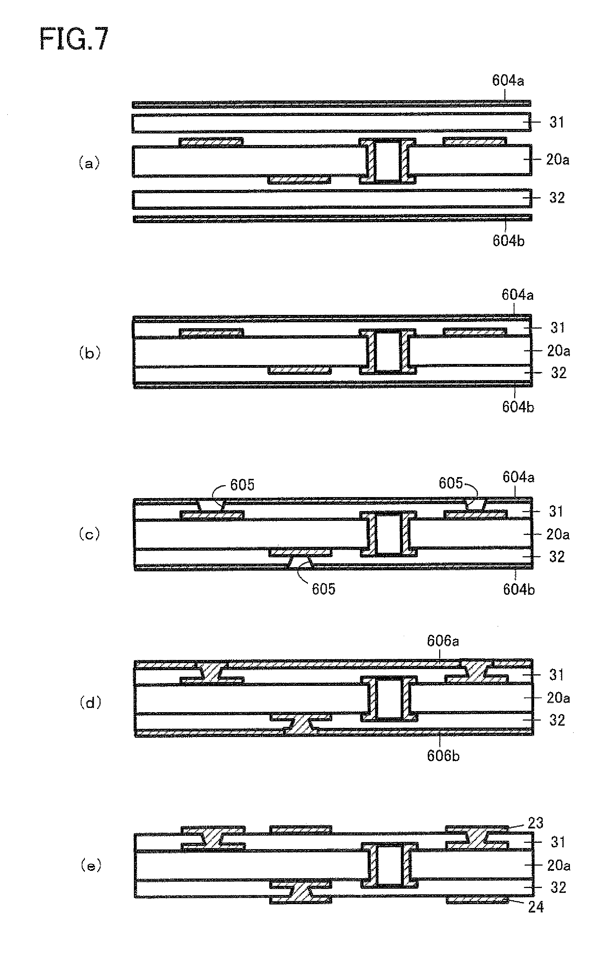

When forming second wiring layers, as shown in FIG. 7(a), for example, on the front and back of the structure having the first wiring layers formed above, insulating materials 31, 32 made with prepreg, for example, and conductive films 604a, 604b made of copper foil, for example, are disposed respectively. Then, using, for example, hydraulic pressing equipment, pressure is exerted on outermost conductive films 604a, 604b to pressure-press the entire structure as shown in FIG. 7(b), for example.

Next, after trimming (edge cutting and marking), drilling a hole for alignment, soft etching and conducting a laser pre-treatment, vias 605 are formed using laser, for example, as shown in FIG. 7(c). Furthermore, after conducting desmear (removing smears) and soft etching, conductive films 606a, 606b are formed as shown in FIG. 7(d), for example, on the front and back of the structure by performing PN plating (such as chemical copper plating and electrical copper plating). Then, after conductive films 606a, 606b are formed, a process inspection is conducted to inspect whether there are any recesses.

In the following, conductive films 606a, 606b are each patterned through a predetermined photo-etching process (such as washing with acid, laminating a resist, direct drawing (exposing to light), developing, etching, removing the film and so forth), and wiring layers 23, 24 are formed, for example, as shown in FIG. 7(e). In doing so, the second wiring layers of second substrate 20 are also formed. Then, an inspection using an image checker or the like and a black oxide treatment are conducted to start forming further upper-layer third wiring layers.

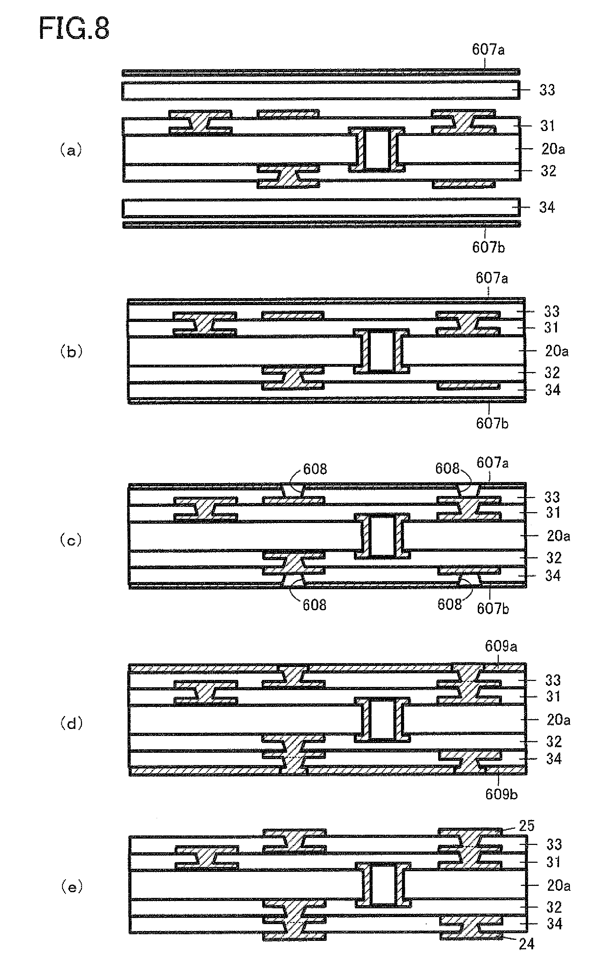

When forming third wiring layers, as shown FIG. 8(a), for example, on the front and back of the structure having the first and second wiring layers formed above, insulating materials 33, 34 made with, for example, prepreg, and conductive films 607a, 607b made of, for example, a copper foil, are disposed respectively. Then, using, for example, hydraulic pressing equipment, pressure is exerted on outermost conductive films 607a, 607b to pressure-press the entire structure as shown in FIG. 8(b), for example.

Next, after trimming (edge cutting and marking), drilling a hole for alignment, soft etching and conducting a laser pre-treatment, vias 608 are formed using laser, for example, as shown in FIG. 8(c). Furthermore, after conducting desmear (removing smears) and soft etching, conductors 609a, 609b are formed respectively on the front and back of the structure as shown in FIG. 8(d), for example, by performing PN plating (such as chemical copper plating and electrical copper plating). Then, after conductors 609a, 609b are formed, a process inspection is conducted to inspect if there are any recesses.

In the following, conductive films 609a, 609b are each patterned through a predetermined photo-etching process (such as washing with acid, laminating a resist, direct drawing (exposing to light), developing, etching, removing the film and so forth), and wiring layers 25, 26 are formed, for example, as shown in FIG. 8(e). In doing so, the third wiring layers of second substrate 20 are also formed and second substrate 20 is completed.

After producing first substrate 10 and second substrate 20 as above, all the substrates 10, 20 formed on substrate 100 and substrate 200 are inspected for quality to determine which substrates are normal and which substrates are flawed (defective). Substrates 10, 20 determined as defective here are discarded as required. When inspecting substrates 10, 20, an inspection using, for example, an image checker or the like is conducted. Then, substrates 10, 20 are each further processed by a black-oxide treatment.

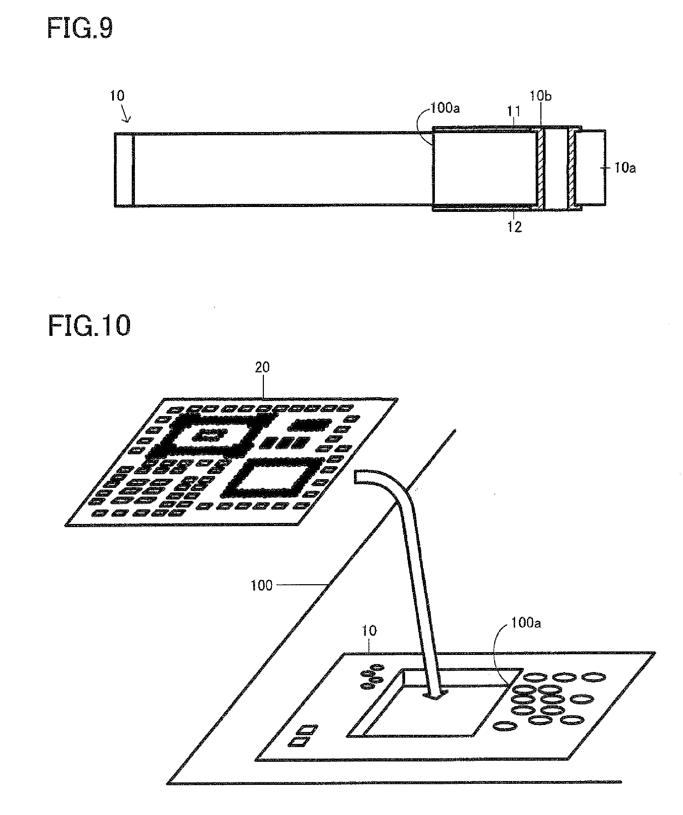

Next, as shown in FIG. 9, first substrate 10 on substrate 100 is cut by laser (laser cutting), for example, to form accommodation section 100a which is a space for accommodating a predetermined number (which is one, here) of second substrate 20. Accommodation section 100a is set to have a configuration (such as a rectangular hollow space) and a size with sufficient space for positioning when second substrate 20 is accommodated.

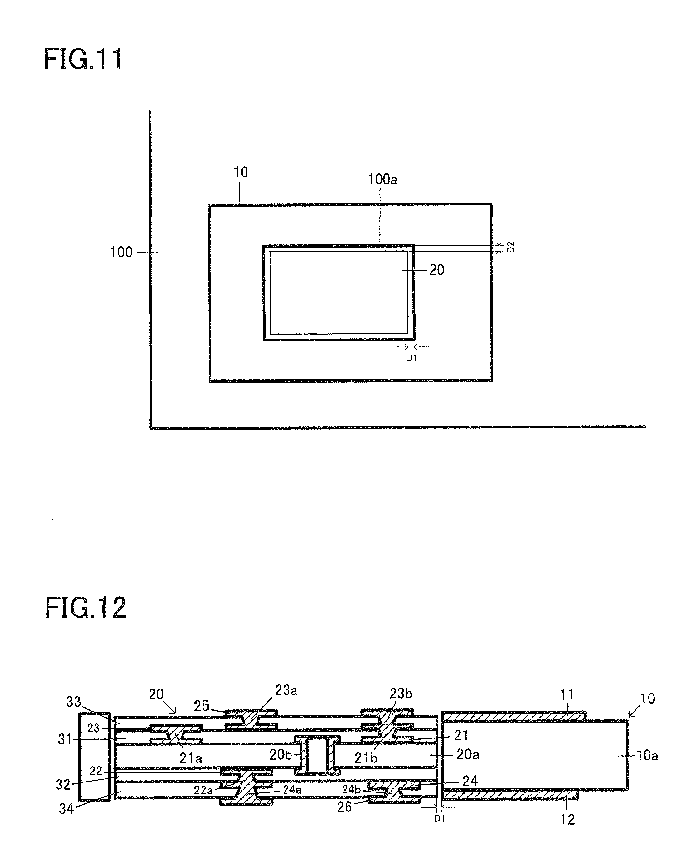

In the following, second substrate 20 determined as normal in the above inspection is cut out from single substrate 200 using laser, for example, as a chip with a predetermined size as shown in FIG. 10. Then, as a plan view and a cross-sectional view shown in FIGS. 11, 12 respectively, for example, a chip of second substrate 20 is accommodated in accommodation section 100a. Then, using sheet-type deposition equipment, a hot-melting adhesive agent is melted to temporarily deposit both substrates (for example, four units). During that process, since accommodation section 100a has a hollow configuration corresponding to the external form of second substrate 20, namely, a hollow configuration which is made larger than second substrate 20 by predetermined spaces D1, D2 (each being a space that is small, but sufficient for performing positioning of the second substrate 20), second substrate 20 may be aligned in a predetermined position (where accommodation section 100a) is positioned.

When filling resin 30 in spaces D1, D2, an adhesive agent may be poured using, for example, a dispenser. Alternatively, an adhesive agent may be applied in accommodation section 100a beforehand, and a chip of second substrate 20 may be accommodated in accommodation section 100a.

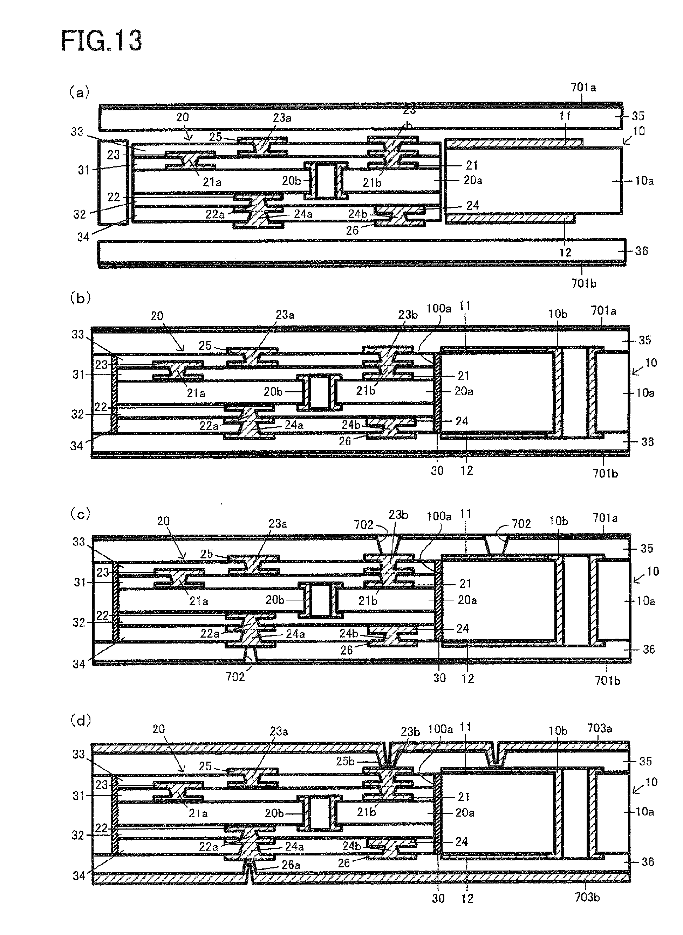

Next, on the front and back of the structure, insulating material 35 made of, for example, an RCF having copper foil 701a on its surface and insulating material 36 made of, for example, an RCF having copper foil 701b on its surface are disposed respectively, for example, as shown in FIG. 13(a). Then, using, for example, hydraulic pressing equipment, outermost-layer copper foils 701a, 701b are pressed to pressure-press the entire structure as shown in FIG. 13(b), for example. Through the pressing, resin is squeezed out from insulating materials 35, 36, and resin 30 is filled in spaces D1, D2 (FIG. 11) between second substrate 20 and accommodation section 100a. As described above, since insulating materials 35, 36 are arranged on the front and back of resin 30, and the resin that forms insulating materials 35, 36 and resin 30 are made of the same material, resin 30 may be easily formed (filled) in spaces D1, D2 by using insulating materials 35, 36.

Next, after trimming (edge cutting and marking), drilling a hole for alignment, soft etching and conducting a laser pre-treatment, vias 702 are formed using laser or the like, for example, as shown in FIG. 13(c). Furthermore, after conducting desmear (removing smears) and soft etching, conductive films 703a, 703b are formed, for example, as shown in FIG. 13(d), on the front and back of the structure by performing PN plating (such as chemical copper plating and electrical copper plating). Then, conductive films 703a, 703b are patterned, for example, by a predetermined photo-etching process (such as washing with acid, laminating a resist, direct drawing (exposing to light), developing, etching, removing the film and so forth) to form wiring layers 41, 42 as shown in FIG. 1. Accordingly, printed wiring board 300 is completed.

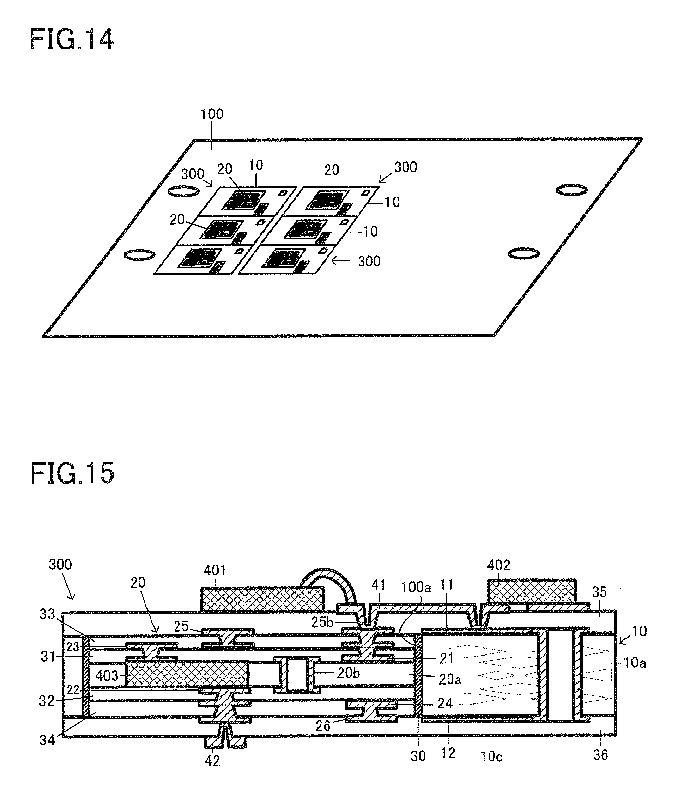

As shown in FIG. 14, multiple printed wiring boards 300 are also formed on a single substrate so as to correspond to the number of first substrates 10 and second substrates 20. Namely, by cutting out such printed wiring boards as chips, each chip will make a product. By making such a structure, the number of wiring layers of printed wiring board 300 lowers, thus reducing unnecessary portions for connecting conductors. Accordingly, its tolerance to impact from being dropped is enhanced.

The above embodiment may be practiced after being modified as follows.

At least either first substrate 10 or second substrate 20 may be connected to at least one electronic component. For example, as shown in FIG. 15, using wire bonding, flip-chip mounting or the like, electronic components 401, 402 are mounted on the surface of printed wiring board 300 to electrically connect them by means of, for example, LPSR, gold wiring or the like to first substrate 10 and second substrate 20 respectively. Also, as electronic component 403 is shown in the drawing, an electronic component may be directly connected to second substrate 20, where it is embedded. A substrate with such a complex structure may be easily manufactured by additionally producing second substrate 20 and embedding it in printed wiring board 300, instead of laminating the same. Here, the number of electronic components is optional.

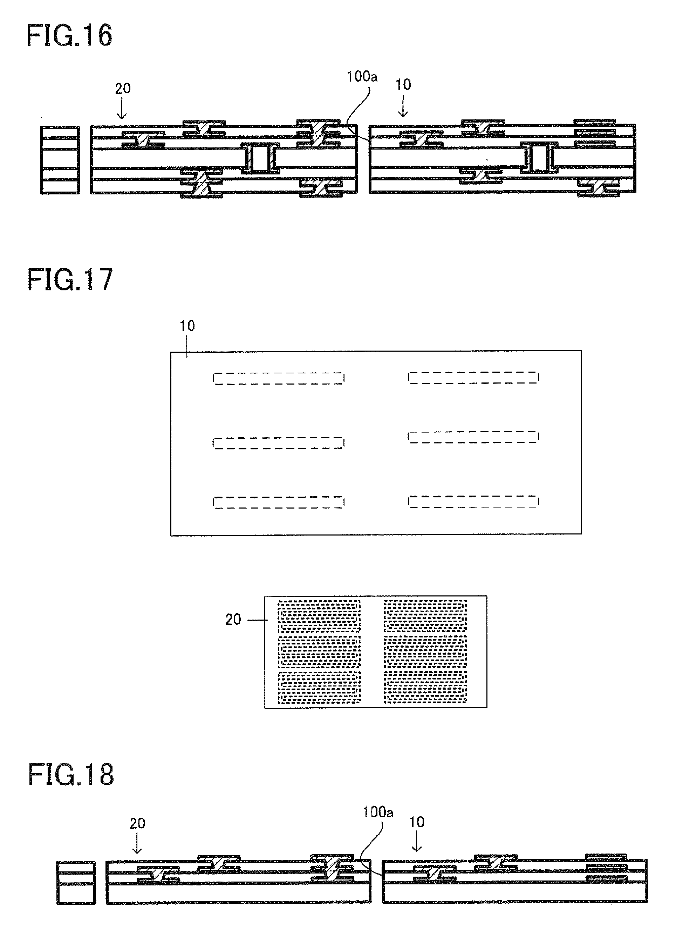

The second substrates, with a higher conductor density than the first substrate, are not limited to those having a greater number of wiring layers per unit thickness than the first substrate. As shown in FIG. 16, for example, even when the number of wiring layers per unit thickness is the same in both substrates, second substrate 20 may be formed in such a way that the number of vias per interlayer insulation layer is greater than in first substrate 10. Here, vias are holes (holes for interlayer connection) that are formed in an interlayer insulation layer to electrically connect the lower-layer wiring layer and the upper-layer wiring layer. IVHs, such as plated through-holes, plated microvias, or conductive-paste coated connection holes, may be employed. Furthermore, even if the number of wiring layers and the number of vias are the same, as shown in FIG. 17, for example, the conductor density on an insulation layer in second substrate 20 may be made greater than the conductor density on an insulation layer in first substrate 10.
The thickness of the core substrate of second substrate 20 may be set equal to the thickness of first substrate 10 (for example, see FIG. 16). Also, as shown in FIG. 18, first substrate 10 and second substrate 20 may have conductors (wiring layers) only on either the front or back of the core substrate.

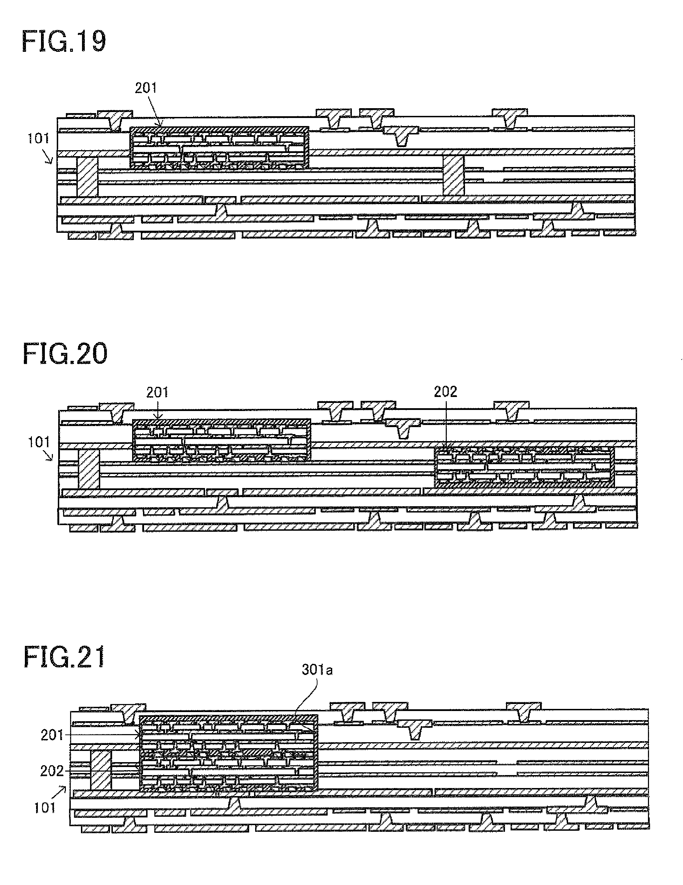

In the above embodiment, first substrate 10 and second substrate 20 are electrically connected through upper-layer wiring layers. However, the method for connecting these two substrates is not limited to this connection method, but it is optional. For example, as shown in FIG. 19, a second substrate (substrate 201 with a higher conductor density) may be electrically connected using a flip-chip method to the first substrate (substrate 101 with a lower conductor density).

Multiple second substrates may be embedded in one first substrate. For example, as shown in FIG. 20, in a printed wiring board having a first substrate (substrate 101 with a lower conductor density), two second substrates (substrates 201, 202 with a higher conductor density) may be embedded. Alternatively, as shown in FIG. 21, multiple second substrates (in this example, two: substrates 201, 202) may be accommodated in one accommodation section 301a.

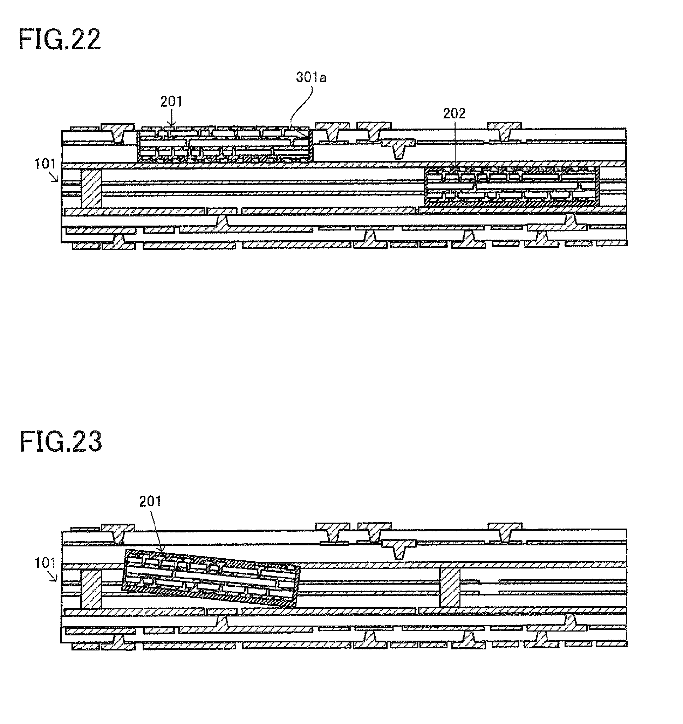

Furthermore, as shown in FIG. 22, without embedding, substrate 201 with a higher conductor density is arranged in hollow section (accommodation section) 301 a formed on the surface of the printed wiring board. A printed wiring board may be formed by combining such substrate 201 and substrate 202 (second substrate) embedded in the printed wiring board. Having such a structure, a high-density conductor region may be easily formed on the substrate surface as well as inside the substrate.

The material for first substrate 10 and second substrate 20 is optional. Substrates 10, 20 may be made of the same material or different materials.

The configuration and position of second substrate 20 as well as its posture at that position are also optional. For example, as shown in FIG. 23, a second substrate (substrate 201 with a higher conductor density) may be set inclined with respect to the first substrate (substrate 101) with a lower conductor density. Also, a roughened surface may be formed in the second substrate, or the second substrate itself may be formed in a V-shape.

In the above embodiment, accommodation section 100a is formed after inspecting first substrate 10 and second substrate 20. However, each substrate may be inspected after forming accommodation section 100a.

The configuration and size of accommodation section 100a are optional. However, considering the positioning of second substrate 20, its configuration and size are preferred to correspond to second substrate 20.

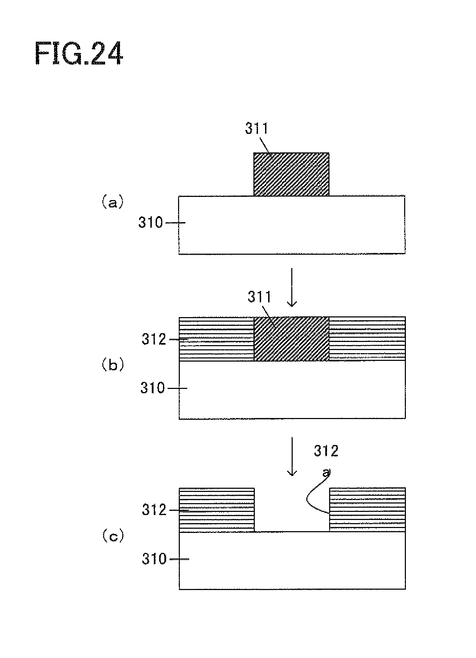

Forming an accommodation section is not limited to a method in which a portion corresponding to its space is removed by laser or the like. For example, accommodation section 312a may also be formed as follows: sacrificial material 311 is formed on substrate 310 beforehand as shown in FIG. 24(a), and multilayer film 312 (multilayer in this example, but a single layer may also be employed) is formed as shown in FIG. 24(b). Then, sacrificial material 311 is removed by selective etching or the like after the film is formed as shown in FIG. 24(c).

Embodiments of the present invention have been explained above. However, various modifications to embodiments and combinations thereof necessitated by design considerations and other factors should be considered to fall within the scope of the invention as claimed in the claims and the invention corresponding to the specific examples described in the Best Mode for Carrying out the Invention.

This application is based on U.S. provisional application No. 61/071,790 filed on May 19, 2008, the entire disclosure of which is incorporated herein by reference in its entirety.

### Industrial Applicability

The present invention is applicable to a printed wiring board of an electronic device, etc.

## Claims

1. A printed wiring board, comprising:
a first substrate having a conductor; and
at least one second substrate whose conductor density is higher than that of the first substrate, the at least one second substrate having a conductor, wherein:
the conductor of the first substrate and the conductor of the second substrate are electrically connected; and
at least one of the first substrate and the second substrate is embedded in the printed wiring board.

2. The printed wiring board according to Claim 1, wherein:
a number of wiring layers formed of the conductor of the second substrate is greater than a number of wiring layers of the first substrate in a region thereof where a thickness of the first substrate is equal to that of the second substrate.

3. The printed wiring board according to Claim 1, wherein
each of the first substrate and the second substrate has an insulating layer; and a conductor density on the insulating layer of the second substrate is higher than a conductor density on the insulating layer of the first substrate.

4. The printed wiring board according to Claim 1, wherein:
the first substrate and the second substrate have a lower wiring layer and an upper wiring layer electrically connected through vias in an interlayer insulating layer; and
a number of vias per unit interlayer insulating layer of the second substrate is greater than a number of vias per unit interlayer insulating layer of the first substrate.

5. The printed wiring board according to Claim 1, wherein:
the first substrate and the second substrate are separated from each other; and
a resin exists in at least a portion of a space between the first substrate and the second substrate.

6. The printed wiring board according to Claim 5, wherein:
an insulating material is disposed at least one of the front and back of the resin; and
the resin comprised in the insulating material and the resin in the space between the first substrate and the second substrate are made of a same material.

7. The printed wiring board according to Claim 1, wherein:
at least one of the first substrate and the second substrate has an insulating layer containing an inorganic material.

8. The printed wiring board according to Claim 7, wherein:
at least one of the insulating layer of the first substrate and the insulating layer of the second substrate has at least one cloth layer with the inorganic material.

9. The printed wiring board according to Claim 7, wherein:
a number of insulating layers containing the inorganic material of the first substrate is greater than a number of insulating layers containing the inorganic material of the second substrate.

10. The printed wiring board according to Claim 1, wherein:
a thickness of at least a portion of the conductor of the second substrate is smaller than a thickness of the conductor of the first substrate.

11. The printed wiring board according to Claim 1, wherein:
at least one electronic component is electrically connected to at least one of the first substrate and the second substrate.

12. The printed wiring board according to Claim 1, wherein:
at least one electronic component is electrically connected to the second substrate.

13. A method for manufacturing a printed wiring board, comprising:
a first step of producing a first substrate having a conductor;
a second step of producing, on a single substrate, a considerable number of second substrates having a conductor;
a third step of forming an accommodation section, which is a space for accommodating the second substrate, in the first substrate produced in the first step;
a fourth step of accommodating at least one of the second substrates in the accommodation section formed in the third step;
a fifth step of electrically connecting the conductor of the first substrate and the conductor of the second substrate; and
a sixth step of embedding the second substrate by laminating a predetermined material on the second substrate accommodated in the fourth step and on the first substrate which accommodates the second substrate.

14. The method for manufacturing a printed wiring board according to Claim 13, further comprising:
a substrate inspecting step of inspecting, prior to the fourth step, each of the first substrate fabricated in the first step and the second substrates fabricated in the second step on a pass-fail basis, wherein:
in the fourth step, at least one of the second substrates determined to be normal in the substrate inspecting step is accommodated in the accommodation section in the first substrate determined to be normal in the substrate inspecting step.

15. The method for manufacturing a printed wiring board according to Claim 13, wherein:
in the third step, an accommodation section having a space is formed so that positioning is possible in the space even when the second substrates are accommodated therein.
